# EUROPEAN PATENT APPLICATION

(11) **EP 4 258 830 A1**
(43) Date of publication of application: **11.10.2023**
(21) Application number: 22167259.5
(22) Date of filing: 07.04.2022
(51) Int. Cl.: H05K 7/02, H05K 7/14

(54) **MODULAR INFORMATION SYSTEM**

(71) Applicant: Televic Rail NV, 8870 Izegem (BE)
(72) Inventor: VANDEKERCKHOVE, Sander, B-8710 Ooigem (BE); BOERJAN, Kristof, B-8310 Assebroek (BE); STUYTS, Yorick, B-8200 Sint-Andries (BE)
(74) Representative: IPLodge bv

(57) **Abstract**

The present invention concerns a modular information system, comprising at least one base unit and a set of extension units, wherein each of said base unit and extension units comprises a housing with an essentially beam-like shape with a predefined height (H), a predefined depth (D) and a width (W), whereby the height and depth are in essence the same for all units, wherein the first lateral side of each unit is essentially open and the second lateral side of each unit is essentially closed with the exception of one or more slits for providing access to a neighbouring unit, wherein each unit comprises a board, said board comprising at least one inter-unit connector module which is aligned with and faces at least one of the slits, wherein the boards of two neighbouring units are connected via a board linking device stretching between said boards through said at least one of the slits, comprising a first connecting device at a first edge of the board linking device, which first connecting device is connected to the inter-unit connector module of a first of said two neighbouring units, the board linking device comprising a second connecting device at a second edge of the board linking device opposite the first edge, which second connecting device is connected to the inter-unit connector module of a second of said two neighbouring units, whereby the first connecting device and the second connecting device are electrically connected, preferably via a set of connection links on the board linking device.

## Description

### Technical field

The present invention relates to the field of information systems, and in particular to a modular system allowing customization to specific needs. The modular system can be configured to fit in a standard rack, e.g. a 3-unit 19-inch rack.

### Background

Information systems, and in particular passenger information systems (PIS), can be found on many types of railway vehicles. The exact functionality of the PIS, however, may depend on the type of railway vehicle. Consequently, in the past, it was required that the hardware (HW) of the PIS was coadapted to these needs, in particular with respect to size and connection possibilities. Together with different HW needs, one further also have to take into account other software (SW) requirements, which could lead to additional changes in HW components.

A standard way of adapting the HW of the PIS, was to redesign a large 3-unit 19-inch rack containing the required processor boards, interface boards, power supplies, etc. for the specific needs of the railway vehicle. This is difficult for PIS providers to manage, because they have to ensure maximal configuration for many different types of railway vehicles. This has a number of drawbacks:
- Large installations are typically required to ensure maximal configuration
- Redesigning the HW is costly in terms of expensive mechanics, test and assembly work because of the multitude of boards and complex cabling between them
- The redesigning cost cannot be easily suppressed by a large-volume effect, as usually only small quantities are needed
- Each type of railway vehicle requires an amount of HW and mechanical (re)design that needs to be tested for that particular vehicle
- Proprietary communication between processor and interface boards often requiring redesign due to new interface needs, even if actual functionality is not considered
- Module management, management overhead, planning, stock, articles, documentation and maintenance (bug fixes, obsolescence,...) are extensive due to the large amount of variations
- Long time-to-market due to the adaptations and required certification steps
- No high ingress protection (IP) ratings possible: the high development costs of higher ingress protection ratings cannot be leveraged across multiple projects or vehicle types
- Challenging thermal design as cooling towards housing is practically non existing in this concept
- Upgrading a PIS may require additional redesigning and maintenance can be difficult
- Customized hardware design tends to require customized software as well, hence the workload and costs for designing, maintaining, repairing and upgrading are particularly high

Document US9730339 discloses a Common Bus Structure for Avionics and Satellites (CBSAS) which is comprised of a module lid, module floor, module stack base, module compression bolts and stackable modules. Stackable modules are sub-dividable to create module scaled chamber volumes individually as required, while stackable modules simultaneously create at least one collectively continuous raceway sealed chamber volume perpendicular to individual stackable modules in the vertical direction where no module floor is present, in order to internally electrically interconnect the contents of any stackable module with the contents of any other stackable module via internal connector raceway system. Raceway sealed chamber volume therefore collectively and continuously traverses all present stackable modules positioned between module lid and module stack base. Modules are interchangeable and inter-connectable in any order, and contain all required electronic or mechanical components required for CBSAS to function as a single box consolidated avionics system that is equally functional in the atmosphere or the vacuum of space, while also being fully functional as a single complete stand-alone satellite system. CBSAS enables a paradigm shift in the aerospace industry whereby all legacy and current multiple black-box systems on aerospace platforms such as missiles, rockets, satellites and aircraft are extremely inefficient when compared to the size, weight and power attributes of CBSAS. The ability for CBSAS to be instantly employable as either a single box consolidated avionics system for use within the atmosphere or in space while also being fully functional as a stand-alone satellite enables a hardware, firmware and software capability never before manifested in the aerospace industry.

The present day solutions tend to be expensive for developing and testing, and tend not to provide enough flexibility to be reused on other vehicle types.

The present invention aims to provide a system which allows easy configuration of a PIS, for many different types of vehicles and requirements.

### Summary of the invention

The present invention concerns a modular information system, comprising at least one base unit and a set of extension units, preferably the set comprising at least one extension unit, more preferably at least 2 extension units, such as 2, 3, 4, 5, 6, 7, 8, 9, 10 or more extension units. The present invention also relates to a kit for constructing a modular information system, comprising at least one base unit and a set of extension units.

Each unit comprises a housing with an essentially beam-like shape with a predefined height (H), a predefined depth (D) and a width (W), whereby the height and depth are in essence the same for all units, and preferably whereby the width is also the same for all units. Preferably the predefined height corresponds to a 3-unit rack height, such that the units can be fitted in a 3-unit rack.

The housing of each unit comprises an essentially rectangular closed top side having the predefined depth and the width, an essentially rectangular closed bottom side having the predefined depth and the width and facing the top side, an essentially rectangular closed front side having the predefined height and the width, and an essentially rectangular closed back side having the predefined height and the width and facing the frontside. The housing also comprises an essentially rectangular first lateral side having the predefined height and the predefined depth, which first lateral side is preferably essentially open, and an essentially rectangular second lateral side having the predefined height and the predefined depth and facing the first lateral side, which second lateral side is preferably essentially closed with the exception of one or more slits. The open first lateral side can be closed off by a housing lid or by a second lateral side of a neighbouring unit. This allows to save on costs and weight and improves accessibility during maintenance. In the present document, the depth direction coincides with the front-to-back direction and is in essence perpendicular to the front side and the back side, the height direction corresponds to the top-to-bottom direction and is in essence perpendicular to the top side and the bottom side, and the width direction corresponds to the lateral direction and is in essence perpendicular to the first lateral side and the second lateral side.

Preferably, the system comprises the base unit and a set of at least one extension unit, said units being arranged in a row in the width direction. Since the units have essentially the same height and depth, the second lateral side of a first unit essentially matches the first lateral side of a second unit neighbouring the first unit, thereby forming an essentially beam-like stack of units, which stack comprises the predefined height and depth, and whose width essentially corresponds to the sum of the widths of the units forming the stack.

In a preferred embodiment, the housings of at least two units, and more preferably of all units, are essentially identical. In case of a stack of units, preferably the housings of all units in the stack are identical, optionally with the exception of the first unit, where variations can be expected due to electrical interfaces on the first lateral side. Hereby, in particular, the housings preferably comprise the same width.

The second lateral side of each unit comprises at least one slit. Preferably, the second lateral side of each unit is closed off with the exception of said slit. Hence, the second lateral side can act as a cover for the first lateral side of a neighbouring unit.

Each unit comprises at least one board, said board comprising at least one inter-unit connector module for connecting the board of one unit with the board of a neighbouring unit, said inter-unit connector module which is preferably (i) a connector socket, such as an edge connector socket, a cable connector socket, or a board-to-board connector socket, or (ii) a connector plug, such as a cable connector plug, or a board-to-board connector plug, or (iii) a combination of these. The board of the base unit preferably comprises at least one, more preferably exactly one, inter-unit connector module, aligned with and facing a slit, which is preferably the slit in the second lateral side of the base unit. An extension unit preferably comprises a board with at least two, and more preferably exactly two, inter-unit connector modules. The two inter-unit connector modules on this board do not have to be similar or of the same type or sex. The first inter-unit connector module faces and is aligned with the slit in the second lateral side of the extension unit and the second inter-unit connector module faces and is aligned with the slit of a neighbouring unit which is situated at the first lateral side.

The term "inter-unit" in this document, is used to indicate that the component which it refers to, is specifically configured to allow connecting boards of different units, e.g. the board of a base unit with the board of an extension unit, or the board of a first extension unit with the board of a second extension unit. It should be noted that a board may comprise other connector modules which may for instance allow connection to other components within the same unit.

Note that in the context of the present invention, a 'socket' herein refers to a female-type connector device having an insertion opening for establishing an electrical connection with a corresponding plug, and a 'plug' herein refers to a male-type connector device having a connection protrusion for establishing an electrical connection with a corresponding socket.

Preferably, the board of a unit, preferably of each unit, is arranged in the housing of the unit essentially parallel to the second lateral side. Preferably, the board is located on or near the first lateral side or the second lateral side, i.e. the board is located away from the middle of the housing towards one of the lateral sides. Most preferably, the board is fixed on or near the second lateral side. Optionally the board is thermally coupled to the second lateral side. This arrangement allows better attachment but also better thermal regulation.

The boards of two neighbouring units, and preferably of each pair of neighbouring units, are connected via a board linking device between said boards through a slit, the board linking device comprising a first board connecting device, which is connected to an inter-unit connector module of a first of said two neighbouring units, and a second board connecting device, which is connected to an inter-unit connector module of a second of said two neighbouring units, whereby the first connecting device and the second connecting device are electrically connected, e.g. to pass electronic signals and/or electric power, preferably whereby the first connecting device and the second connecting device are connected via a set of electric connection links on the board linking device. Preferably the inter unit connector modules on the boards of the neighbouring units allow a small amount of slack to the board connecting devices of the board linking device, preferably said slack being at least 0.2 mm and preferably at most 3 mm.

The first board connecting device and/or the second board connecting device of the board linking device are the counterparts of the inter-unit connector modules on the board of the first unit and the board of the second unit.

In case an inter-unit connector module on one of the boards of two neighbouring units comprises an edge connector socket, then said board linking device comprises a board or card or connection card, stretching between said boards through a slit, this connection card comprising contacts on the first edge, which edge is inserted in the edge connector socket of said inter-unit connector module Preferably the connection card is connected to the edge connector socket via a sliding contact. This allows a small amount of slack to the connection card to be placed between two board of neighbouring units.

Alternatively, in case an inter-unit connector module on one of the boards of two neighbouring units comprises a board-to-board connector socket, then said board linking device comprises a board or card or connection card, stretching between said boards through a slit, this connection card comprising a board to board connector on the first edge, which board-to-board connector is plugged on or inserted in the board-to-board connector of said inter-unit connector module. Preferably the board-to-board connector composition allows a small amount of slack to the connection card to be placed between two board of neighbouring units.

Alternatively, and in particular in case the inter-unit connection modules on the boards of two neighbouring units comprises cable connectors, then the board linking device comprises a cable and the boards of two neighbouring units are connected via a cable stretching between said boards through a slit, the cable comprising a first cable connector on a first end which is inserted in or plugged onto the board connector of the inter-unit connector module of a first of said two neighbouring units, and a second cable connector on a second end of the cable, which second cable connector is inserted in or plugged onto the board connector of the inter-unit connector module of a second of said two neighbouring units.

We note that the inter-unit connector modules of the boards of multiple units in a system according to the present invention, do not have to be of the same kind, i.e. the inter-unit connector modules of the boards of multiple units in the system may be a combination of connector sockets and connector plugs.

We note that the board linking device can be a combination of one or more cables and one or more cards, and that this or these cable(s) and/or this or these card(s) may run through one or more slits.

We note that in a preferred embodiment, all board linking devices are essentially the same. This allows for a fully modular approach. Only in case where the units have a different width, the dimensions of the board linking devices may differ.

The present invention also concerns a method for constructing a modular information system, comprising the steps of:
- providing at least one base unit and a set of extension units in accordance with the present invention;
- stacking the base unit and extension units in a row oriented in a width direction of the base unit and extension units, whereby the units are stacked next to each other such that the heights and the depths of neighbouring units in the row correspond, and, for each pair of neighbouring units, connecting the boards of the neighbouring units via a board linking device through the slit of one of the neighbouring units, by plugging or inserting a first connecting device of the board linking device onto or into the inter-unit connector module of the board of the first unit, and by plugging or inserting a second connecting device of the board linking device onto or into the inter-unit connector module of the board of the second unit, thereby obtaining a stack of units which are interconnected in a daisy-chain configuration, and
- optionally placing the stacked row of units in a rack.

Further, the present invention concerns a base unit for a modular information system. Also, the present invention concerns an extension unit for a modular information system.

### Description of the figures

**Figure 1** shows a top cross sectional view of a system according to the present invention comprising a base unit and two extension units.
**Figure 2** illustrates a kit and a system according to the present invention, wherein the units and boards of the units are shown in a separated way for clarity.
**Figure 3** illustrates a unit according to the present invention.

### Detailed description of the invention

The present invention will now be further disclosed with reference to the figures.

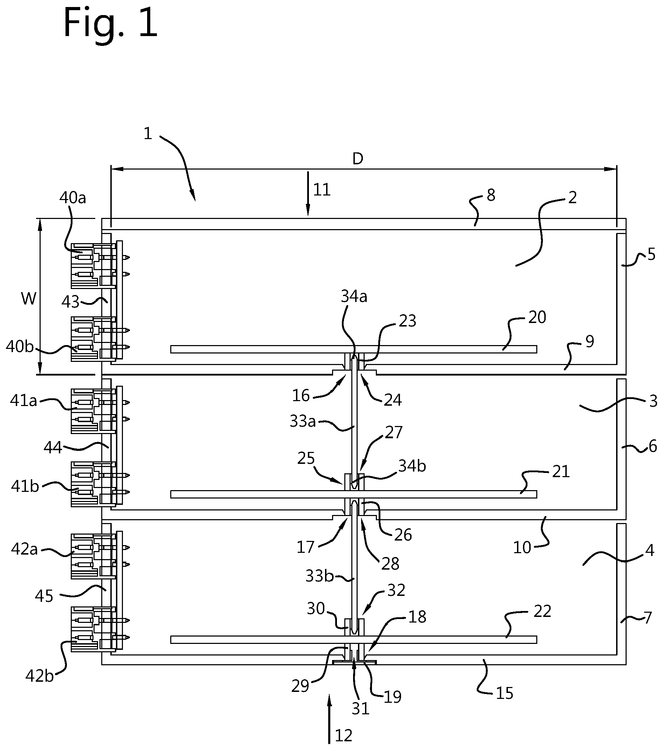

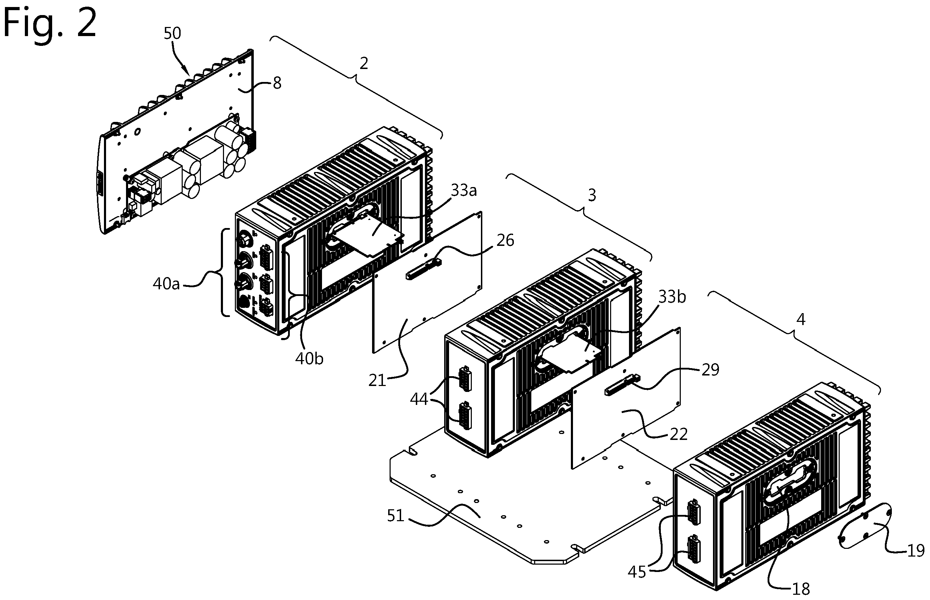

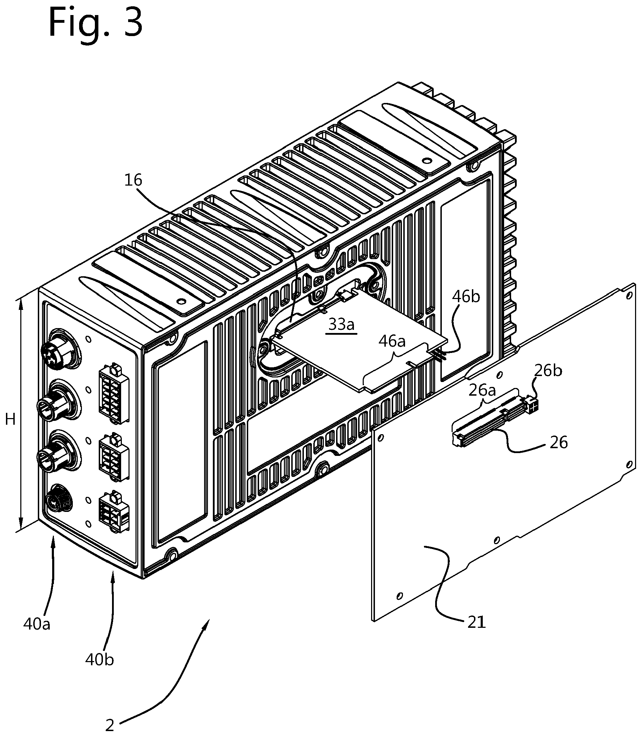

The modular information system (1) of the present invention comprises at least one base unit (2) and a set of extension units (3, 4), of which two are shown on fig. 1. The units are also shown separated in fig. 2 in a perspective view and an enlarged part showing the base unit and part of the first extension unit in fig.3. The units are herein stacked in a row oriented in a width direction, whereby the units are stacked next to each other such that the heights and the depths of neighbouring units in the row correspond. Preferably the base unit (2) is positioned at a first lateral end (11) of the row, and the extension units (3, 4) are positioned next to one another and stretch from the base unit (2) to a second lateral end (12) of the row.

The housing (5) of the base unit (5) comprises an essentially beam-like shape with a predefined height (H), a predefined depth (D) and a width (W). The extension units (3, 4) each comprise a housing (6, 7) with the same height (H) and depth (D), and in the exemplary embodiment of figs. 1, 2 and 3 also essentially the same width. Preferably the predefined height corresponds to a 3-unit rack height, such that the units can be fitted in a 3-unit rack. The housing of the base unit also comprises a cover (8) to close off the base unit on the first lateral side. The second lateral side (9) of the base unit (8) acts as a cover for the first lateral side of the neighbouring extension unit (3), and the second lateral side (10) of the first extension unit (3) acts as a cover for the first lateral side of the second extension unit (4) neighbouring the first extension unit.

Preferably the predefined height corresponds to a 3-unit rack height, such that the units can be fitted within a 3-unit rack. Hence, the predefined height is preferably at most 133.35 mm, and preferably at least 122mm, more preferably at least 124mm, yet more preferably at least 126mm, still more preferably at least 128mm, even more preferably at least 130mm, such as 130mm, 131mm, 132mm, 133.35 or any value therebetween an higher up to 133.35mm. In an embodiment, the system comprises an attachment plate (51) onto which the units are attached. In such embodiments, the predefined height is preferably at most 133.35 mm minus the thickness of the attachment plate,

The second lateral sides (9, 10, 15) of the base unit and the two extension units shown in fig. 1, each comprise one slit (16, 17, 18). The second lateral side of each unit is closed off with the exception of said slit. Consequently, the second lateral sides of the base unit (2) and the first extension unit (3) act as a cover for the first lateral sides of the first extension unit (3) and the second extension unit (4) respectively.

In a preferred embodiment of the invention, the slit in a second lateral side of the last unit is closed off, preferably using a slit closing plate (19), or the slit in a first lateral side of the first unit is closed off, preferably using a slit closing plate. Herein, the last unit refers to the unit which is positioned at the second lateral end (12) of the stack of units and the first unit refers to the unit positioned at the first lateral end (11) of the stack of units.

Each unit is provided with a board (20, 21, 22). The base unit (2) comprises a board (20) with exactly one inter-unit connector module, which comprises a board-to-board connector (not shown) and/or an edge connector socket (23) in the figure, although other connector sockets may also be provided. The first extension unit (3) comprises a board with two inter-unit connector modules (25, 26), each comprising a board-to-board connector and/or an edge connector socket (25, 26), of which a first inter-unit connector module (26) is facing to and aligned with the slit (17) in the second lateral side (10) of the extension unit and of which a second inter-unit connector module (25) is oriented oppositely and facing to and aligned with a slit (16) of a neighbouring unit. The second extension unit (4) also comprises a board with two inter-unit connector modules, each comprising a board-to-board connector and an edge connector socket (29, 30), of which a first inter-unit connector module is facing to and aligned with the slit (18) in the second lateral side (10) of the extension unit and of which a second inter-unit connector module is oriented oppositely and facing to and aligned with a slit (17) of a neighbouring unit, and, in fig. 1, is closed off by the slit closing plate (19). It should be clear that the system can be extended with more units, by stacking these units in a row onto the second lateral side of the second extension unit. Hereby, the slit closing plate (19) may be removed, i.e. preferably the slit closing plate (19) is removably attached to the extension unit in the present invention, such that the board of the following unit at the second lateral side of the second extension unit may be interconnected to the board of the second extension unit. As most notably shown in fig. 3, the inter-unit connector modules are preferably a combination of an edge connector socket (26a) and a board-to-board pin connector socket (26b), but other types of connectors, such as a cable connectors, or any combination of edge connectors, cable connectors and board-to-board connectors is possible. The edge connector socket (26a) is hereby configured to receive an edge connector plug (46a) from the board linking device (33a) and the board-to-board pin connector socket is configured to receive a board-to-board pin connector plug (46b). Further note that for the present invention, it is preferred that the inter-unit connector modules are contained within the housing of the unit. This allows the first lateral side of the housing and the slit of the housing to be easily closed off.

Note that in a preferred embodiment of the present invention, the board linking device comprises:
- a connection card comprising:
   ∘ a first edge connector plug on a first edge of the connection card and a second edge connector plug on a second edge of the connection card opposite to the first edge, and/or
   ∘ a first board-to-board connector plug on a first edge of the board-to-board connection card and a second board-to-board connector plug on a second edge of the connection card opposite to the first edge,
      and/or
- a cable comprising a first cable plug on a first edge of the cable and a second cable plug on a second edge of the cable opposite to the first edge.

The boards of two neighbouring units, for instance the base unit (2) and the first extension unit (3), can be connected via a connection card (33a) comprising at a front end (i) a first series of contacts (34a) on a first edge, which contacts (34a) are inserted in the edge connector socket (23) of the inter-unit connection module of the board of the base unit, and (ii) a board-to board connector plug, comprising pins which are inserted in the board-to-board connector socket of the inter-unit connection module of the board of the base unit; and at a back end (i) a second series of contacts (34b) on a second edge which is opposite to the first edge, which contacts (34b) are inserted in the edge connector socket (25) of the inter-unit connection module of a board on the first extension unit, and (ii) a board-to board connector plug, comprising pins which are inserted in the board-to-board connector socket of the inter-unit connection module of the board of the first extension unit. The first edge connector series of contacts and the second edge connector series of contacts are electrically connected, preferably electrically connected via a set of connection links on the connection card. The first board-to-board connector pins and the second board-to board connector pins are electrically connected, preferably electrically connected via a set of connection links on the connection card. In the illustrated figure, the first and/or second edge connector plug is connected to an inter-unit edge connector socket via a sliding contact. This allows a small amount of slack to the connection card to be placed between two board of neighbouring units. Due to the nature of this connector, the connection is 'mechanically floating', meaning it can cope with mechanical tolerances in all directions (XYZ), with a very low cost. Guidance of the edge card integrated in the housing makes it very easy to assemble and fool-proof.

The connection links on the connection card allow transferring electrical signals and electrical power from unit to unit, and more particular from board to board over several units. The boards of the units of the stack can thus be preferably connected in a daisy chain, using a chain of connection cards. As such, electrical power and electrical signals, e.g. data signals such as analog data signals and/or digital data signals, can be transferred from the base unit to any extension unit, between any two extension units, or between more than two units, such as is desired for e.g. broadcasting signals. The connection card preferably comprises a board, i.e. a connection card board, which can preferably be provided with electrically conducting connection links, more preferably the connection card comprises a printed circuit board (pcb). The pcb preferably comprises electrically conducting strips which can act as connection links.

In an embodiment, the connection links comprise passive connection links. Alternatively or additionally, the connection links comprise active connection links. Passive connection links allow transferring of electrical signals and/or power without substantially altering or interfering with the transferred signals or power. Active connection links alter and/or interfere with the electrical signals and/or power in the transfer. For instance, an active connection link may comprise a repeater, an electronic filter and/or signal integrity electronics.

The present invention allows to make the connection, design and integration of (multiple) extension units as easy as possible with minimal cost. In addition, the challenging thermal environment and the ingress protection (IP) ratings can be guaranteed. Contrary to the typical solution of using a single specific and expensive bus protocol which meets all requirements, the proposed solution routes commonly supported communication protocols (USB, Ethernet, I2C, UART,...) in such a way that they are extendable to an unspecified number of extension boards.

The base unit can be stacked with multiple extension units. Preferably the base unit comprises a board comprising a processor. The processor on the board in the base unit is preferably to be connected electrically with the boards in the extension units. By interconnecting all neighbouring boards, a daisy chain type connection can be set up.

All the housings (i.e. for base unit, first extension unit, second extension unit,..) are preferably identically shaped, using only 1 type of housing for all configurations.

With the exception of the slit in the second lateral side, the unit housings are preferably open only on the first lateral side. This specific construction has been chosen for optimal thermal performance :
- The second lateral side of the unit can be configured for optimizing thermal performance, e.g. the second lateral side may be provided with a cooling system and/or a heat regulating system. The second lateral side itself may also preferably comprise or be a thermal conducting plate to which critical components can be cooled by means of a thermal pad. The second lateral side is preferably profiled and may have provisions to put additional thermal pads. This is another thermal optimization, i.e. by means of assembling an additional cooling plate, the thermal performance of the unit can be further improved for tough environments.
- The sides of the units may preferably be profiled or may preferably comprise two flat surfaces for better thermal contact when mounted on sideways. The first and second lateral sides preferably comprise an attachment arrangement for attaching different units to each other without needing to open the housings. This allows the extension units to be mounted to the base unit without opening the base unit or extension units. It also allows to connect as many extension units as needed. The attachment arrangement preferably comprises a set of screw holes in the housing and corresponding screws, e.g. at the corners and/or at the circumference of the first lateral side and/or of the second lateral side.
- The front side of the unit is preferably used for connectivity with external components.
- The back side of the unit can preferably be used for adding a heatsink for cooling or also as additional connectivity side, i.e. interface connection may be provided on the back side of the unit. An integrated heatsink makes that the cost and performance of the part is thermally optimal, i.e. this creates a bigger surface for conduction cooling.
- The first lateral side is preferably open, allowing to make different configurations: to plug it as extension or to close it via a plate or to add a heatsink for an additional cooling. Different heatsinks are possible depending on the environmental requirements. The mechanical module allows for a cheap and easy high IP rating, such as IP54, IP65, IP67 or higher. Note that combination of a high IP rating and thermal behavior and small size is not trivial, due to no natural convection from inside the housing.
- By adding a sealing gasket between neighbouring units on the edges of the first lateral side and/or second lateral side, the system can be made IP65 compliant and even higher. A sealing member may also be provided at the slit closing plate (19). Note that detaching the slit closing plate allows direct access to the boards of the full system, and allows debugging and/or programming. Hence, any unit may be reprogrammed or debugged via the inter-unit connector socket of the last unit, which is accessible through the slit in the second lateral side.

In an embodiment, one of the extension units is a power supply unit (PSU). Preferably said PSU is located at the first lateral end or at the second lateral end. Also, the PSU is preferably provided with a heat sink.

In the shown example, the base unit and the extension units comprise a set of interface connections (40a, 40b, 41a, 41b, 42a, 42b) on the front side (43, 44, 45) of the housing, which interface connections are operationally connected to the boards (20, 21, 22) of the respective units. The connections between the interface connections and the boards may preferably comprise electrically conducting wiring, additional pcb's, or one or more interface connections may be arranged directly on the board of the unit. The interface connections preferably comprise an input/output (I/O) component on an outer side of the housing of the unit, such that signals and/or power may be accessed via the interface connection and made available to and from other hardware components of the PIS, such as speakers, microphones, database connections (e.g. via a TCP/IP uplink), etc. The functionality of the system can thus be customized at will, by choosing the required number and types of units.

In a preferred embodiment, at least two neighbouring units, and preferably all neighbouring units are attached to one another in a water tight manner and/or in a dust tight manner. Preferably, the system comprises a rubber gasket between two neighbouring units, the rubber gasket being provided around the edges of the second lateral side of a first of said two neighbouring units and the edges of the first lateral side of a second of said two neighbouring units, thereby providing a tight attachment between the two neighbouring units, such as a watertight and/or dust tight attachment. Preferably, the housing comprises a groove around the edges of the second lateral side of a first of said two neighbouring units and/or around the edges of the first lateral side of a second of said two neighbouring units for accommodating a gasket. The neighbouring units may be attached to each other using a set of attachment screws, attachment bolts, clamp, and/or glue. Preferably, neighbouring units are detachably attached to one another to allow easy replacement of or access to a unit. Preferably, the first lateral side of the first unit of a stack of connected units is covered, e.g. by a housing lid, and/or the slit of the last unit of a stack of connected units is covered, e.g. by a slit covering plate. Hereby, preferably the system comprises a gasket between the housing lid and the first lateral side of the first unit of the stack, the gasket provided around the edges of the first lateral side of the first unit in the stack. Preferably hereby the housing comprises a groove around the edges of the first lateral side of first unit of the stack for accommodating a gasket. Also, preferably the system comprises a slit gasket between the second lateral side of the last unit of the stack and the slit covering plate. Hereby preferably, a unit in accordance with the present invention, and in particular the last unit of a stack, comprises a groove around the slit in the second lateral side of the unit for accommodating a slit gasket and/or the slit covering plate comprises a groove around the edges of the slit covering plate for accommodating a slit gasket.

In the embodiment illustrated in the figures, the housings of the units are essentially identical, i.e. they have the same width, as well as the same height and depth. However, in other embodiments, the units may not have the same width. In that case, at least one connection card connecting a unit with deviating width to a neighbouring unit may have a deviating size, allowing connection of the boards to be made.

In a preferred embodiment, a unit according to the invention comprises a heat sink, preferably on or near the first lateral side and/or on or near the second lateral side of the unit. Alternatively or additionally, a heat sink may be provided on or near the top side and/or the bottom side of the unit. This is better shown in figure 2, wherein the units are shown separately in a perspective view, and thereby illustrate the system and the kit according to the present invention. Herein, the first lateral side (8) of the base unit (2) comprises a heat sink (50) allowing improved dissipation of heat.

In an embodiment, the system comprises an attachment plate (51) onto which the units are attached. Analogously, the kit preferably comprises an attachment plate onto which the units can be attached. The attachment plate allows easy stacking of the base unit and extension units in a row oriented in a width direction of the base unit and extension units, whereby the units are stacked next to each other such that the heights and the depths of neighbouring units in the row correspond. Once attached, the row of units can be handled as a single component which can be easily placed in a rack.

In an embodiment the attachment plate (51) comes in the form of a so called rack tray or rack cradle, by preference in a 3U format.

## Claims

1. A modular information system, comprising at least one base unit and a set of extension units, wherein each of said base unit and extension units comprises a housing with an essentially beam-like shape with a predefined height (H), a predefined depth (D) and a width (W), whereby the height and depth are in essence the same for all units,
wherein the housing of each unit comprises an essentially rectangular first lateral side having the predefined height and the predefined depth, an essentially rectangular second lateral side having the predefined height and the predefined depth and facing the first lateral side, an essentially rectangular closed top side having the predefined depth and the width, an essentially rectangular closed bottom side having the predefined depth and the width and facing the top side, an essentially rectangular closed front side having the predefined height and the width, and an essentially rectangular closed back side having the predefined height and the width and facing the front side,
wherein the first lateral side of each unit is essentially open and the second lateral side of each unit is essentially closed with the exception of one or more slits for providing access to a neighbouring unit,
wherein each unit comprises a board, said board comprising at least one inter-unit connector module which is aligned with and faces at least one of the slits,
wherein the boards of two neighbouring units are connected via a board linking device stretching between said boards through said at least one of the slits, comprising a first connecting device at a first edge of the board linking device, which first connecting device is connected to the inter-unit connector module of a first of said two neighbouring units, the board linking device comprising a second connecting device at a second edge of the board linking device opposite the first edge, which second connecting device is connected to the inter-unit connector module of a second of said two neighbouring units, whereby the first connecting device and the second connecting device are electrically connected, preferably via a set of connection links on the board linking device.

2. A modular information system according to claim 1, wherein the at least one inter-unit connector module comprises an edge connector socket, a cable socket, a cable plug, a board-to-board connector socket, a board-to-board connector plug, or a combination thereof.

3. A modular information system according to claim 2, wherein the board linking device comprises:
- a connection card comprising:
∘ a first edge connector plug on a first edge of the connection card and a second edge connector plug on a second edge of the connection card opposite to the first edge, and/or
∘ a first board-to-board connector plug on a first edge of the board-to-board connection card and a second board-to-board connector plug on a second edge of the connection card opposite to the first edge,
and/or
- a cable comprising a first cable plug on a first edge of the cable and a second cable plug on a second edge of the cable opposite to the first edge.

4. A modular information system according to any of the preceding claims, whereby the width is the same for all units.

5. A modular information system according to any of the preceding claims, wherein the predefined height corresponds to a 3-unit rack height, such that the units can be fitted in a 3-unit rack.

6. A modular information system according to any of the preceding claims, wherein the housings of at least two units, and more preferably of all units, are essentially identical.

7. A modular information system according to any of the preceding claims, wherein the board of the base unit comprises an inter-unit connector module which is aligned with and faces the slit in the second lateral side of the base unit or which is aligned with and faces the slit in a first lateral side of a neighbouring unit.

8. A modular information system according to any of the preceding claims, wherein an extension unit comprises at least two inter-unit connector modules, of which a first inter-unit connector module is aligned with and faces the slit in the second lateral side of the extension unit and of which a second inter-unit connector module is aligned with and faces a slit of a neighbouring unit.

9. A modular information system according to any of the preceding claims, wherein the boards of the units are connected in a daisy chain.

10. A modular information system according to any of the preceding claims, wherein at least one unit comprises a heat sink, preferably on or near the first lateral side and/or on or near the second lateral side of the unit.

11. A modular information system according to any of the preceding claims, wherein the board linking device is a connection card comprising a printed circuit board which comprises electrically conducting strips which act as connection links.

12. A modular information system according to any of the preceding claims, wherein at least one of the base unit and the extension units comprise a set of interfaces on the front side of the housing, which interface connections are operationally connected to the boards of the at least one unit.

13. A kit for constructing a modular information system, comprising at least one base unit and a set of extension units, wherein each of said base unit and extension units comprises a housing with an essentially beam-like shape with a predefined height (H), a predefined depth (D) and a width (W), whereby the height and depth are in essence the same for all units,
wherein the housing of each unit comprises an essentially rectangular first lateral side having the predefined height and the predefined depth, an essentially rectangular second lateral side having the predefined height and the predefined depth and facing the first lateral side, an essentially rectangular closed top side having the predefined depth and the width, an essentially rectangular closed bottom side having the predefined depth and the width and facing the top side, an essentially rectangular closed front side having the predefined height and the width, and an essentially rectangular closed back side having the predefined height and the width and facing the front side,
wherein the first lateral side of each unit is essentially open and the second lateral side of each unit is essentially closed with the exception of one or more slits,
wherein the kit comprises a set of boards configured to fit in the units in a predetermined manner, each board comprising at least one inter-unit connector module which is aligned with and faces a slit when the board is placed in a unit in the predetermined manner, wherein the kit comprises a set of connection cards and/or connection cables, each comprising a series of contacts on a first edge of the board/cable linking device and a series of contacts on a second edge of the board/cable linking device opposite the first edge, wherein the boards of two neighbouring units are configured to be connected via connection cards and/or connection cables by insertion of a first series of contacts in the inter-unit connector module of a first of said two neighbouring units, and by insertion of a second series of contacts in the inter-unit connector module of a second of said two neighbouring units, whereby the first series of contacts and the second series of contacts are electrically connected, preferably via a set of connection links on the board linking device.

14. A unit for a modular information system according to any of the claims 1 to 12 or for a kit according to claim 13, wherein the unit comprises a housing with an essentially beam-like shape with a predefined height (H), a predefined depth (D) and a width (W),
wherein the housing comprises an essentially rectangular first lateral side having the predefined height and the predefined depth, an essentially rectangular second lateral side having the predefined height and the predefined depth and facing the first lateral side, an essentially rectangular closed top side having the predefined depth and the width, an essentially rectangular closed bottom side having the predefined depth and the width and facing the top side, an essentially rectangular closed front side having the predefined height and the width, and an essentially rectangular closed back side having the predefined height and the width and facing the front side,
wherein the first lateral side of each unit is essentially open and the second lateral side of each unit is essentially closed with the exception of one or more slits for providing access to a neighbouring unit,
wherein the unit comprises a board, said board comprising at least one inter-unit connector module which is aligned with and faces the slit,
wherein the board is configured to be connected to a board of a neighbouring unit via a connection board and/or connection cable by insertion of a first series of connectors on a first edge of the connection board and/or connection cable in the inter-unit connector module of the unit, and by insertion of a second series of connectors on a second edge of the connection board and/or connection cable opposite the first edge, in the inter-unit connector module of the neighbouring unit, whereby the first series of connectors and the second series of connectors are electrically connected, preferably via a set of connection links on the board linking device.

15. A method for constructing a modular information system according to any of the claims 1 to 12, comprising the steps of:
- providing at least one base unit and a set of extension units according to claim 14;
- stacking the base unit and extension units in a row oriented in a width direction of the base unit and extension units, whereby the units are stacked next to each other such that the heights and the depths of neighbouring units in the row correspond, and connecting the boards of neighbouring units via a board linking device through the slit of one of the neighbouring units by insertion of a first series of connectors on a first edge of the connection board and/or connection cable in the inter-unit connector module of a first of said neighbouring units, and by insertion of a second series of contacts on a second edge of the connection board and/or connection cable opposite the first edge, in the inter-unit connector module of a second of said neighbouring units, and
- optionally placing the stacked row of units in a rack.
